# EUROPEAN PATENT APPLICATION

(11) **EP 4 431 539 A1**
(43) Date of publication of application: **18.09.2024**
(21) Application number: 23888970.3
(22) Date of filing: 19.10.2023
(51) Int. Cl.: C08G 59/40, C08G 59/62, C08L 63/00, C08L 63/04, C08K 3/36, H05K 1/03

(54) **RESIN COMPOSITION AND PRINTED CIRCUIT BOARD COMPRISING SAME**

(30) Priority: 07.11.2022 KR 20220147208
(71) Applicant: LG Chem, Ltd., Yeongdeungpo-gu Seoul 07336 (KR)
(72) Inventor: PARK, Jun Wuk, Daejeon 34122 (KR); KIM, Tae Soon, Daejeon 34122 (KR); YOON, Youngsik, Daejeon 34122 (KR); CHOI, Byung Ju, Daejeon 34122 (KR)
(74) Representative: Plasseraud IP
(86) International application number: PCT/KR2023/016214
(87) International publication number: WO 2024/101707

(57) **Abstract**

The resin composition according to an exemplary embodiment of the present application comprises: an epoxy-based resin; a curing agent comprising a cyanate ester-based resin and a phenolic resin; inorganic particles comprising silica particles; and a curing accelerator, the weight ratio of the cyanate ester-based resin : the phenolic resin is 95 : 5 to 40 : 60, and the curing accelerator comprises both an imidazole-based compound and a metal-based compound.

## Description

### [Technical Field]

This application claims priority to and the benefit of Korean Patent Application No. 10-2022-0147208 filed in the Korean Intellectual Property Office on November 7, 2022, the entire contents of which are incorporated herein by reference.

The present application relates to a resin composition and a printed circuit board comprising the same.

### [Background Art]

Generally, double-sided printed circuit boards are based on a copper clad laminate (CCL), which is manufactured by laminating a copper foil on both sides of an insulating member. In order to connect electrical signals to the copper foil on both sides, holes are processed using a drill, and electrolytic copper plating is used to connect the copper foil on both sides to the plating layer, and then a pattern is selectively formed by applying a UV-sensitive dry film for forming a circuit and irradiating the UV-sensitive dry film with UV light. Thereafter, the double-sided printed circuit board may be manufactured by a process of etching the pattern to form a circuit pattern on the copper foil on both sides, and then applying a photoimageable solder resist (PSR) for insulation, and subjecting the surface where a final part is to be mounted to surface treatment such as gold plating.

Further, a multilayer printed circuit board may be manufactured by a process, which is the same up to the forming of the circuit on a double-sided board, forms a circuit pattern, and then again laminates a prepreg and a copper foil one by one on top of the other instead of applying the PSR thereon, and then heats and presses the laminate. Therefore, the multilayer printed circuit board refers to a build-up board in which a PCB is formed in multiple layers.

In this case, for the multilayer printed circuit board, a via hole that electrically connects an inner layer circuit pattern and an outer layer circuit pattern through laser processing may be formed, and a plated layer may be formed on the inner surface of the via hole to manufacture the printed circuit board. Thereafter, if necessary, a solder resist layer may be further formed as a protective layer on the plated layer, or more outer layers may be further formed.

In the art, in order to improve the quality of multilayer printed circuit boards, there is a need for insulating layers that not only have excellent adhesion to a conductor wiring constituting a conductive layer but also have excellent chemical resistance.

### [Detailed Description of the Invention]

### [Technical Problem]

The present application has been made in an effort to provide a resin composition and a printed circuit board comprising the same.

### [Technical Solution]

An exemplary embodiment of the present application provides a resin composition comprising:
an epoxy-based resin;
a curing agent comprising a cyanate ester-based resin and a phenolic resin;
inorganic particles comprising silica particles; and
a curing accelerator,
in which a weight ratio of the cyanate ester-based resin : the phenolic resin is 95 : 5 to 40 : 60, and
the curing accelerator comprises both an imidazole-based compound and a metal-based compound.

In addition, another exemplary embodiment of the present application provides a printed circuit board comprising the resin composition or a cured product thereof.

### [Advantageous Effects]

A resin composition according to an exemplary embodiment of the present application can have excellent curing properties by applying a cyanate ester-based resin and a phenolic resin, which have a specific weight ratio, as a curing agent and applying a curing accelerator comprising both an imidazole-based compound and a metal-based compound. Furthermore, an insulation film prepared using the resin composition according to an exemplary embodiment of the present application can have an appropriate surface roughness through desmear treatment, and thus has excellent adhesion to copper foil.

Therefore, a multilayer printed circuit board having excellent wiring adhesion, chemical resistance, and the like can be manufactured using the resin composition according to an exemplary embodiment of the present application.

### [Best Mode]

Hereinafter, the present application will be described in more detail.

When one member is disposed "on" another member in the present application, this comprises not only a case where the one member is brought into contact with another member, but also a case where still another member is present between the two members.

When one part "comprises" one constituent element in the present application, unless otherwise specifically described, this does not mean that another constituent element is excluded, but means that another constituent element may be further comprised.

A method for manufacturing a multilayer printed circuit board in which a conductor layer and an insulation film are alternately laminated has been developed, and thus, is currently being used for semiconductor packaging applications. The manufacturing process of the multilayer printed circuit board is as follows: first, a build-up insulation film is vacuum laminated on top of an inner layer circuit, and then the build-up insulation film is subjected to processes of precure → drilling → desmear → electroless plating → electrolytic plating → postcure → outer layer circuit formation. Here, the desmear process removes the smear using an acidic solution and simultaneously erodes a certain amount of the surface of the insulation film to form surface roughness, which serves to enhance adhesion to a copper foil layer formed in the subsequent processes.

Although, as a resin composition for the build-up insulation film, a composition in which an epoxy resin and a phenolic curing agent are filled with silica particles as an inorganic filler was used in initial products, products using cyanate ester-based curing agents in epoxy resins have been developed as a need for low dielectric properties and low CTE increases.

However, although the cured products of the epoxy resin and cyanate ester resin have advantages such as low CTE and high heat resistance, there is a problem in that desired surface roughness cannot be formed through the desmear process when the cured product is used alone.

Accordingly, the present application has been made in an effort to provide a resin composition that not only has excellent curing properties but also can form a desired surface roughness even after the desmear process, and a printed circuit board comprising the resin composition.

The resin composition according to an exemplary embodiment of the present application comprises: an epoxy-based resin; a curing agent comprising a cyanate ester-based resin and a phenolic resin; inorganic particles comprising silica particles; and a curing accelerator, the weight ratio of the cyanate ester-based resin : the phenolic resin is 95 : 5 to 40 : 60, and the curing accelerator comprises both an imidazole-based compound and a metal-based compound.

In an exemplary embodiment of the present application, it is preferred that the epoxy-based resin has two or more epoxy groups in one molecule. More specifically, the epoxy-based resin may comprise one or more of a bisphenol A-type epoxy resin, bisphenol F-type epoxy resin, a bisphenol S-type epoxy resin, a naphthalene-type epoxy resin, an anthracene epoxy resin, a biphenyl-type epoxy resin, a tetramethyl biphenyl-type epoxy resin, a phenol novolac-type epoxy resin, a cresol novolac-type epoxy resin, a bisphenol A novolac-type epoxy resin, a bisphenol S novolac-type epoxy resin, a biphenyl novolac-type epoxy resin, a naphthol novolac-type epoxy resin, a naphthol phenol cocondensed novolac-type epoxy resin, a naphthol cresol cocondensed novolac-type epoxy resin, an aromatic hydrocarbon formaldehyde resin modified phenol resin-type epoxy resin, a triphenylmethane-type epoxy resin, a tetraphenylethane-type epoxy resin, a dicyclopentadiene phenol addition reaction-type epoxy resin, a phenol aralkyl-type epoxy resin, a naphthol aralkyl-type epoxy resin, and the like.

Among them, from the viewpoint of heat resistance, insulation reliability, and adhesion, it is more preferred that the epoxy resins comprise one or more of a bisphenol A-type epoxy resin, a naphthol-type epoxy resin, a naphthalene-type epoxy resin, a biphenyl-type epoxy resin, an epoxy resin with a butadiene structure, and the like.

In an exemplary embodiment of the present application, the curing agent comprises a cyanate ester-based resin and a phenolic resin.

The cyanate ester-based resin may comprise one or more selected from among a novolac-type (phenol novolac-type, alkylphenol novolac-type, and the like) cyanate ester-based resin, a dicyclopentadiene-type cyanate ester-based resin, a bisphenol-type (bisphenol A-type, bisphenol F-type, bisphenol S-type, bisphenol M-type) cyanate ester-based resin, and a prepolymer in which these are partially triazined.

More specifically, the cyanate ester-based resin may comprise one or more selected from among a difunctional cyanate resin such as bisphenol A dicyanate, polyphenol cyanate, oligo(3-methylene-1,5-phenylene cyanate), 4,4'-methylenebis(2,6-dimethylphenyl cyanate), 4,4'-ethylidenediphenyl dicyanate, hexafluoro bisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl)thioether, and bis(4-cyanatephenyl)ether; a polyfunctional cyanate resin derived from a phenol novolac, cresol novolac, a dicyclopentadiene structure-containing phenol resin, or the like; and a prepolymer in which these cyanate resins are partially triazined.

The weight average molecular weight of the cyanate ester-based resin may be 500 g/mol to 4,500 g/mol, and may be 600 g/mol to 3,000 g/mol, but is not limited thereto.

In the present application, the weight average molecular weight may be measured by a gel permeation chromatography (GPC) method (polystyrene equivalent).

The phenolic resin is a compound comprising a phenol skeleton or a naphthol skeleton, and may comprise a novolac-type phenolic resin having excellent heat resistance, water resistance, and the like. More specifically, the phenolic resin may comprise a novolac resin such as a phenol novolac resin, a bisphenol A novolac resin, a cresol novolac resin, a phenol-modified xylene resin, an alkylphenol resin, and a phenol-modified melamine resin.

In an exemplary embodiment of the present application, the weight ratio of the cyanate ester-based resin : the phenolic resin may be 95 : 5 to 40 : 60, may be 90 : 10 to 40 : 60, and may be 88 : 12 to 45 : 55. When the content of the cyanate ester-based resin is less than 40 wt% based on the total weight of the cyanate ester-based resin and the phenolic resin, the content is not preferred because curing properties such as low dielectric loss tangent (low Df) characteristics, low CTE, and high heat resistance, which are the advantages of the cyanate ester-based resin, cannot be obtained. Further, when the content of the phenolic resin is less than 5 wt%, the content is not preferred because it may be difficult to implement a desired surface shape through the desmear process.

In an exemplary embodiment of the present application, the weight ratio of the epoxy-based resin : the curing agent may be 60 : 40 to 20 : 80, may be 60 : 40 to 30 : 70, and may be 55 : 45 to 35 : 65. When the weight ratio of the epoxy-based resin : the curing agent is satisfied, excellent heat resistance and mechanical properties may be obtained while having low dielectric loss tangent and low CTE characteristics. When the content of the epoxy-based resin exceeds 60 wt% based on the total weight of the epoxy-based resin and the curing agent, excellent dielectric properties and desired curing properties cannot be obtained because a high degree of curing cannot be obtained through heat treatment, so that the content is not preferred. In addition, when the content of the curing agent exceeds 80 wt%, the content is not preferred because self-crosslinking in which the cyanate ester-based resin is linked to a triazine structure may excessively occur, resulting in brittle fracture in which a film is easily broken after curing.

In an exemplary embodiment of the present application, the inorganic particles comprise silica particles.

In an exemplary embodiment of the present application, the inorganic particles comprise only silica particles, and do not comprise any other inorganic particles other than the silica particles.

The silica particles may have an average particle diameter of 0.3 µm or less, may be 0.2 µm or less, and may be 0.05 µm or more.

When silica with an average particle size of 0.3 µm or less or 0.2 µm or less is used as inorganic particles, it is difficult to obtain desired surface roughness using desmear in the related art. However, according to an exemplary embodiment of the present application, by satisfying the above-described specific weight ratio of the cyanate ester-based resin : the phenolic resin, desired surface roughness may be formed by desmear.

In the related art, a shape in which the inorganic particles protrude or a concave shape caused by the falling off of inorganic particles are formed while the resin composition on the surface layer portion is etched to a certain thickness by a wet desmear treatment, and in this case, the degree of curing of the resin composition and the size of the inorganic particles are important factors that determine the surface roughness. Typically, when products with an average particle size exceeding 0.3 µm are used as inorganic particles, a surface roughness of Ra 200 nm or more may be easily obtained by appropriately adjusting the degree of curing of the resin composition, such that the surface layer portion is well etched by the desmear treatment. However, when silica with an average particle size of 0.3 µm or less or 0.2 µm or less is used, the size of the inorganic particles is small even though the resin composition is well etched, so that it is difficult to obtain a surface roughness of Ra 200 nm or more.

Meanwhile, as in an exemplary embodiment of the present application, when a mixture of a cyanate ester-based resin and a phenolic resin is used at a specific weight ratio, the etching rates for the desmear solution are different from each other due to the difference in curing speed between two resins with respect to epoxy, the difference in chemical resistance, and the like, and as a result, during the desmear process, non-uniform etching of the surface layer portion is induced, so that a surface illuminance of 200 nm or more may be formed regardless of the size of the inorganic particles.

In an exemplary embodiment of the present application, the resin composition may additionally comprise a thermoplastic resin in order to improve the mechanical strength, film formability, and the like of the cured product. The thermoplastic resin may comprise one or more selected from among a phenoxy resin, a polyimide resin, a polyamideimide resin, a polyetherimide resin, a polysulfone resin, a polyethersulfone resin, a polyphenylene ether resin, a polycarbonate resin, a polyvinylacetal resin, a polyvinyl butyral resin, a polyetheretherketone resin, and a polyester resin. It is more preferred that the thermoplastic resin comprises a phenoxy resin.

The weight average molecular weight of the thermoplastic resin may be 5,000 g/mol to 200,000 g/mol, but is not limited thereto.

In an exemplary embodiment of the present application, the resin composition is characterized in that it comprises a curing accelerator in order to efficiently cure the epoxy-based resin, the curing agent, and the like, and the curing accelerator comprises both an imidazole-based compound and a metal-based compound. Further, the curing accelerator may additionally comprise one or more selected from among an amine-based compound and an organic phosphine-based compound in addition to the imidazole-based compound and the metal-based compound.

The imidazole-based compound may serve to promote the curing reaction of the phenolic resin in the curing agent, and the metal-based compound may serve to promote the curing reaction of the cyanate ester-based resin in the curing agent. That is, since the resin composition according to an exemplary embodiment of the present application comprises a cyanate ester-based resin and a phenolic resin as a curing agent, the desired surface roughness effect cannot be obtained when the resin composition does not comprise either the imidazole-based compound or the metal-based compound as the curing accelerator.

When both an imidazole-based compound and a metal-based compound are comprised as the curing accelerator, the etching speeds for the desmear solution for the imidazole-based compound and the metal-based compound are different from each other, due to the difference in curing speed and chemical resistance between the imidazole-based compound and the metal-based compound for the epoxy-based resins, and the like. As a result, non-uniform etching of the surface layer portion is induced during the desmear process, so that a surface roughness of 200 nm or more may be formed regardless of the size of the inorganic particles.

However, when the curing accelerator comprises only any one of the imidazole-based compound and the metal-based compound, the film may crack after curing, and the surface may be over-etched during the desmear treatment, resulting in a whitening phenomenon, which are not preferred.

The imidazole-based compound may comprise one or more of 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanurate adducts, 2-phenylimidazole isocyanurate adducts, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzyl imidazolium chloride, 2-methylimidazoline, 2-phenylimidazoline, and the like.

Examples of the metal-based compound comprise an organometallic complex or organometallic salt of a metal such as cobalt, copper, zinc, iron, nickel, manganese, and tin. The organometallic complex may comprise one or more of cobalt(II) acetylacetonate, cobalt(III) acetylacetonate, copper(II) acetylacetonate, zinc(II) acetylacetonate, iron(III) acetylacetonate, nickel(II) acetylacetonate, manganese(II) acetylacetonate, and the like. In addition, the organometallic salt may comprise one or more of zinc octylate, tin octylate, zinc naphthenate, cobalt naphthenate, tin stearate, zinc stearate, and the like.

Examples of the amine-based compound comprise triethylamine, tributylamine, 4-dimethylaminopyridine, benzyldimethylamine, 2,4,6-tris(dimethylaminomethyl)phenol, 1,8-diazabicyclo(5,4,0)-undecene, and the like.

The content of the curing accelerator may be 0.01 wt% to 5 wt% based on the total weight of non-volatile components of the resin composition.

In an exemplary embodiment of the present application, the resin composition may additionally comprise an additive known in the art. The additive may comprise one or more selected from among a leveling agent, a wetting agent, and an anti-static agent, but is not limited thereto.

In an exemplary embodiment of the present application, the resin composition may be applied to a printed circuit board. More specifically, the resin composition may be applied as an insulation film for a printed circuit board. The insulation film may be used as an interlayer insulation material of a multilayer printed circuit board.

Furthermore, another exemplary embodiment of the present application provides a printed circuit board comprising the resin composition or a cured product thereof.

The printed circuit board may be a multilayer printed circuit board, and the number of layers comprised in the multilayer printed circuit board is not limited. For example, the multilayer printed circuit board may comprise a structure of 2 layers to 20 layers, depending on the purpose and application, and the like of the multilayer printed circuit board.

### [Mode for Invention]

Hereinafter, the present application will be described in detail with reference to Examples for specifically describing the present application. However, the Examples according to the present application may be modified in various forms, and it is not interpreted that the scope of the present application is limited to the Examples described below. The Examples of the present application are provided for more completely explaining the present application to the person with ordinary skill in the art.

### <Examples>

### <Example 1>

After 70 parts by weight of a bisphenol-based epoxy resin (YD-128, KUKDO CHEMICAL CO., LTD.), 30 parts by weight of a phenol novolac-type epoxy resin (YDPN-639, KUKDO CHEMICAL CO., LTD.), 84 parts by weight of a dicyclopentadiene bisphenol-based cyanate ester resin (MEK solution of 75% non-volatile components, C03CS, TECHIA), 24 parts by weight of a biphenyl-based phenol resin (GPH-65, Nippon Kayaku Co., Ltd.), 360 parts by weight of a silica slurry with an average particle diameter of 0.18 µm (MEK solution of 60% non-volatile components, K180SX-CM3, ADMATECHS), 20 parts by weight of a phenoxy resin (YP-50, KUKDO CHEMICAL CO., LTD.), and 110 parts by weight of methyl ethyl ketone (MEK) were mixed, the resulting mixture was stirred at 250 rpm for 3 hours using a mechanical stirrer.

Thereafter, 1.0 part by weight of an imidazole-based curing accelerator (2PHZ-PW, Shikoku Chemicals) and 0.05 parts by weight of a metal-based curing accelerator cobalt(II) acetylacetonate (TCI) were diluted to 10% concentration in MEK and added thereto, and a coating solution was prepared by uniformly dispersing the resulting mixture using a high-speed rotating mixer.

After a PET film having a thickness of 38 µm was coated with the prepared coating solution using an applicator, the coated coating solution was dried at 100°C for 8 minutes to prepare an insulation film having a thickness of 25 µm.

### <Example 2>

An insulation film was prepared using the same content ratio and the same preparation method as in Example 1, except that in Example 1, 98 parts by weight of a novolac-type cyanate ester resin (MEK solution of 75% non-volatile components, C05CS, TECHIA) as a cyanate ester resin and 12 parts by weight of a biphenyl-based phenol resin (GPH-65, Nippon Kayaku Co., Ltd.) were added.

### <Example 3>

An insulation film was prepared using the same content ratio and the same preparation method as in Example 1, except that in Example 1, 56 parts by weight of a dicyclopentadiene bisphenol-based cyanate ester resin (MEK solution of 75% non-volatile components, C03CS, TECHIA) and 48 parts by weight of a biphenyl-based phenol resin (GPH-65, Nippon Kayaku Co., Ltd.) were added.

### <Example 4>

An insulation film was prepared using the same content ratio and the same preparation method as in Example 1, except that in Example 1, 153 parts by weight of a dicyclopentadiene bisphenol-based cyanate ester resin (MEK solution of 75% non-volatile components, C03CS, TECHIA) and 24 parts by weight of a biphenyl-based phenol resin (GPH-65, Nippon Kayaku Co., Ltd.) were added.

### <Comparative Example 1>

An insulation film was prepared using the same content ratio and the same preparation method as in Example 1, except that in Example 1, 112 parts by weight of a novolac-type cyanate ester resin (MEK solution of 75% non-volatile components, C05CS, TECHIA) as a cyanate ester resin was added and a biphenyl-based phenol resin (GPH-65, Nippon Kayaku Co., Ltd.) was not added.

### <Comparative Example 2>

An insulation film was prepared using a preparation method such as the same content ratio as in Example 1, except that in Example 1, 28 parts by weight of a dicyclopentadiene bisphenol-based cyanate ester resin (MEK solution of 75% non-volatile components, C03CS, TECHIA) and 72 parts by weight of a biphenyl-based phenol resin (GPH-65, Nippon Kayaku Co., Ltd.) were added.

### <Comparative Example 3>

An insulation film was prepared using the same content ratio and the same preparation method as in Example 1, except that in Example 1, a dicyclopentadiene bisphenol-based cyanate ester resin was not added and 97 parts by weight of a biphenyl-based phenol resin (GPH-65, Nippon Kayaku Co., Ltd.) was added.

### <Comparative Example 4>

An insulation film was prepared using the same content ratio and the same preparation method as in Example 1, except that in Example 1, 94 parts by weight of a dicyclopentadiene bisphenol-based cyanate ester resin (MEK solution of 75% non-volatile components, C03CS, TECHIA) and 4 parts by weight of a biphenyl-based phenol resin (GPH-65, Nippon Kayaku Co., Ltd.) were added.

### <Comparative Example 5>

An insulation film was prepared using the same content ratio and the same preparation method as in Example 1, except that as a curing accelerator, only a metal-based curing accelerator was added without adding an imidazole-based curing accelerator.

### <Comparative Example 6>

An insulation film was prepared using the same content ratio and the same preparation method as in Example 1, except that as a curing accelerator, only an imidazole-based curing accelerator was added without adding a metal-based curing accelerator.

### <Experimental Example 1>

The characteristics of the insulation films prepared in the Examples and Comparative Examples were evaluated, and are shown in the following Table 1. The method for evaluating the characteristics shown in the following Table 1 is as follows.

### <Coefficient of thermal expansion (CTE)>

After the insulation film was thermally cured at 190°C for 90 minutes, the coefficient of thermal expansion was measured in a range of 25°C to 120°C using a thermos mechanical analyzer (TMA).

### <Surface roughness (Ra, nm)>

### 1) Desmear treatment

The insulation film was compressed and laminated on a copper clad laminate (CCL) substrate under conditions of a temperature of 100°C and a pressure of 0.7 MPa for 30 seconds using a vacuum pressure laminator, and then pre-cured in a hot air oven at 100°C for 30 minutes, and then at 170°C for 30 minutes.

Subsequently, the support film (PET film) of the insulator was peeled off to expose the insulation layer, and then desmear treatment was performed. The desmear treatment was performed in three stages of swelling solution treatment (60°C, 5 minutes) - oxidation solution treatment (80°C, 20 minutes) - neutralization solution treatment (50°C, 4 minutes) using Securiganth MV series treatment solutions manufactured by Atotech.

### 2) Measurement of surface roughness (Ra, nm)

The surface of the desmeared insulation layer was measured five times per sample using an optical profiler (Nanoview 3D surface profiler NV-2700, Nanosystem), and the arithmetic mean roughness (Ra) was determined from the average value.

### <Adhesion to copper foil>

### 1) Copper plating treatment

Copper plating was performed in two stages of electroless chemical copper plating and electrolytic copper plating. Electroless chemical copper plating was performed using a Printoganth MV product manufactured by Atotech, such that the plating thickness was 0.5 µm to 1.0 µm, and after treatment, the sample was dried in a hot air oven at 150°C for 30 minutes.

Electrolytic copper plating was performed using an Expt Inpro SAP6 chemical manufactured by Atotech, such that the plating thickness was about 20 µm, and after treatment, the sample was heat-treated in a hot air oven at 190°C for 1 hour.

### 2) Evaluation of adhesion to copper foil

The 90 degree peel strength of the copper plating layer was measured using a Texture Analyzer (TA-XT Plus) manufactured by Stable Micro Systems. When the measured peel strength was 0.45 kgf/cm or more, it was determined that the adhesion to copper foil was good, and when the measured peel strength was less than 0.45 kgf/cm, it was determined that the adhesion to copper foil was poor.

**[Table 1]**

| | Epoxy resin | Cyanate ester resin | Phenol resin | Coefficient of thermal expansion (CTE) | Surface roughness (Ra) | Adhesion to copper foil |
|---|---|---|---|---|---|---|
| | (Part by weight) | (Part by weight of solid content) | (Part by weight) | (ppm/°C) | (nm) | (Determination) |
| Example 1 | 100 | 63 | 24 | 37 | 282 | Good |
| Example 2 | 100 | 73 | 12 | 36 | 258 | Good |
| Example 3 | 100 | 42 | 48 | 40 | 304 | Good |
| Example 4 | 100 | 115 | 24 | 34 | 245 | Good |
| Comparative Example 1 | 100 | 84 | 0 | 34 | 133 | Poor |
| Comparative Example 2 | 100 | 21 | 72 | 48 | 158 | Poor |
| Comparative Example 3 | 100 | 0 | 97 | 52 | 169 | Poor |
| Comparative Example 4 | 100 | 94 | 4 | 33 | 184 | Poor |
| Comparative Example 5 | 100 | 63 | 24 | - | Surface whitening | - |
| Comparative Example 6 | 100 | 63 | 24 | 44 | Surface whitening | - |

As shown in the results, Examples 1 to 4 exhibited a low coefficient of thermal expansion of 40 ppm/°C or less and good adhesion to copper foil. However, although Comparative Examples 1 and 4 exhibited a low coefficient of thermal expansion of 33 to 34 ppm/°C, the surface roughness (Ra) due to the desmear treatment was 200 nm or less, and the adhesion to copper foil was also poor. Further, in the case of Comparative Examples 2 and 3, the coefficient of thermal expansion was also relatively high, and the adhesion to copper foil was also poor.

In addition, when only a metal-based compound was comprised as a curing accelerator as in Comparative Example 5, the film was easily cracked after curing, making it impossible to prepare samples, and the surface was over-etched during the desmear treatment, resulting in a whitening phenomenon. Furthermore, when only an imidazole-based compound was comprised as a curing accelerator as in Comparative Example 6, the coefficient of thermal expansion was relatively high, and the surface was over-etched during the desmear treatment, resulting in a whitening phenomenon.

Therefore, the resin composition according to an exemplary embodiment of the present application can have excellent curing properties by applying a cyanate ester-based resin and a phenolic resin, which have a specific weight ratio, as a curing agent and applying a curing accelerator comprising both an imidazole-based compound and a metal-based compound. Furthermore, an insulation film prepared using the resin composition according to an exemplary embodiment of the present application can have an appropriate surface roughness through desmear treatment, and thus has excellent adhesion to copper foil.

Furthermore, a multilayer printed circuit board having excellent wiring adhesion, chemical resistance, and the like can be manufactured using the resin composition according to an exemplary embodiment of the present application.

## Claims

1. A resin composition comprising:
an epoxy-based resin;
a curing agent comprising a cyanate ester-based resin and a phenolic resin;
inorganic particles comprising silica particles; and
a curing accelerator,
wherein a weight ratio of the cyanate ester-based resin : the phenolic resin is 95 : 5 to 40 : 60, and
the curing accelerator comprises both an imidazole-based compound and a metal-based compound.

2. The resin composition of claim 1, wherein a weight ratio of the epoxy-based resin : the curing agent is 60 : 40 to 20 : 80.

3. The resin composition of claim 1, wherein the cyanate ester-based resin comprises one or more selected from among a novolac-type cyanate ester-based resin, a dicyclopentadiene-type cyanate ester-based resin, a bisphenol-type cyanate ester-based resin, and a prepolymer in which these are partially triazined.

4. The resin composition of claim 1, wherein the phenolic resin comprises a novolac-type phenolic resin.

5. The resin composition of claim 1, wherein the silica particles have an average particle diameter of 0.3 µm or less.

6. The resin composition of claim 1, wherein the metal-based compound comprises one or more selected from among cobalt(II) acetylacetonate, cobalt(III) acetylacetonate, copper(II) acetylacetonate, zinc(II) acetylacetonate, iron(III) acetylacetonate, nickel(II) acetylacetonate, manganese(II) acetylacetonate, zinc octylate, tin octylate, zinc naphthenate, cobalt naphthenate, tin stearate, and zinc stearate.

7. The resin composition of claim 1, further comprising one or more thermoplastic resins selected from among a phenoxy resin, a polyimide resin, a polyamideimide resin, a polyetherimide resin, a polysulfone resin, a polyethersulfone resin, a polyphenylene ether resin, a polycarbonate resin, a polyetheretherketone resin, a polyester resin, a polyvinylacetal resin, and a polyvinyl butyral resin.

8. The resin composition of claim 1, further comprising one or more selected from among a leveling agent, a wetting agent, and an anti-static agent.

9. The resin composition of claim 1, wherein the resin composition is applied to a printed circuit board.

10. A printed circuit board comprising the resin composition of any one of claims 1 to 9 or a cured product thereof.
